# EUROPÄISCHE PATENTANMELDUNG

(11) **EP 0 780 692 A2**
(43) Veröffentlichungstag der Anmeldung: **25.06.1997**
(21) Anmeldenummer: 96810810.0
(22) Anmeldetag: 19.11.1996
(51) Int. Cl.: G01R 15/16

(54) **Sensor zum Auskoppeln von Teilentladungsimpulsen aus einer hoschspannungsführenden elektrischen Anlage**

(30) Priorität: 22.12.1995 DE 19548466
(71) Anmelder: ABB RESEARCH LTD., 8050 Zürich (CH)
(72) Erfinder: Behrmann, Glenn, 5708 Birrwil (CH)
(74) Vertreter: Liebe, Rainer

(57) **Zusammenfassung**

Dieser Sensor ist zum Auskoppeln von Teilentladungsimpulsen aus einer hochspannungsführenden elektrischen Anlage, insbesondere aus einer mit einer Kapselung (2) aus Metall versehenen gasisolierten Hochspannungsanlage, vorgesehen. Der Sensor ist mit mindestens einer konzentrisch zu den Aktivteilen (1) der Anlage angeordneten, dem elektromagnetischen Feld der Anlage ausgesetzten, etwa ringförmig ausgebildeten Messelektrode versehen. Mit der Messelektrode sind die ausgekoppelten Signale verarbeitende Einrichtungen verbunden.

Es soll ein Sensor geschaffen werden, welcher sich einerseits durch einen hohen Wirkungsgrad bei der Auskoppelung der in der Anlage auftretenden Teilentladungsimpulse und eine vergleichsweise hohe obere Grenzfrequenz auszeichnet, und der es andererseits ermöglicht, unerwünschte, den jeweiligen Teilentladungsimpulsen überlagerte, Störungen auszufiltern. Dies wird dadurch erreicht, dass die etwa ringförmig ausgebildete Messelektrode in mindestens zwei gleiche, voneinander beabstandete, als Elektroden (3a,3b) ausgebildete Segmente aufgeteilt ist, dass die mindestens zwei Elektroden (3a,3b) symmetrisch beidseits der Aktivteile (1) angeordnet sind, und dass die die ausgekoppelten Signale verarbeitenden Einrichtungen Mittel für das Ausfiltern von den ausgekoppelten Teilentladungsimpulsen überlagerten Störungen aufweisen.

## Beschreibung

### TECHNISCHES GEBIET

Bei der Erfindung wird von einem Sensor zum Auskoppeln von Teilentladungsimpulsen aus einer hochspannungsführenden elektrischen Anlage gemäss dem Oberbegriff des Anspruchs 1 ausgegangen. Insbesondere wird der Sensor in einer metallgekapselten gasisolierten Hochspannungsanlage (GIS) eingesetzt. Der Sensor kann aber beispielsweise auch bei der Uberwachung von Transformatoren, Hochspannungskabeln oder sonstigen spannungsführenden Baugruppen oder Anlagen eingesetzt werden.

### STAND DER TECHNIK

Die Erfassung von Teilentladungsimpulsen spielt bei der Überwachung von hochspannungsführenden elektrischen Anlagen, wie etwa einer metallgekapselten gasisolierten Hochspannungsanlage (GIS) oder einem hochspannungsbeaufschlagten elektrischen Gerät, beispielsweise einem Transformator oder einem Generator, eine wichtige Rolle. Teilentladungsmessungen werden sowohl während des Betriebs als auch bei der Qualitätskontrolle während der Fertigung in der Fabrik und auch bei der Qualitätsprüfung während des Vor-Ort-Aufbaus der metallgekapselten gasisolierten Schaltanlage oder des betreffenden Geräts durchgeführt.

Ein Sensor zum Auskoppeln von Teilentladungsimpulsen aus einer hochspannungsführenden elektrischen Anlage (GIS) ist beispielsweise aus der Patentschrift EP 0 134 187 B1 bekannt. Der vorbekannte Sensor weist eine als Metallplatte ausgebildete Messelektrode auf, die in die innere Oberfläche der Metallkapselung einer gasisolierten metallgekapselten Hochspannungsanlage eingelassen ist, allerdings ist der Sensor von der Metallkapselung elektrisch isoliert. Die von dem Sensor aus dieser hochspannungsführenden Anlage kapazitiv ausgekoppelten Teilentladungsimpulse werden in einer dem Sensor nachgeschalteten Signalverarbeitungsvorrichtung weiter verarbeitet. Ein derartiger Sensor ist nicht in der Lage, die dem jeweiligen Teilentladungsimpuls überlagerten hochfrequenten Störungen zu erkennen und auszufiltern.

Aus der Offenlegungsschrift DE 42 21 865 A1 ist ein weiterer Sensor für die Erfassung von in einer metallgekapselten gasisolierten Schaltanlage (GIS) auftretenden Teilentladungsimpulsen bekannt. Die Messelektrode dieses Sensors ist als geschlossener, im Innern der Kapselung konzentrisch zu den Aktivteilen der Schaltanlage angeordneter Ring aufgebaut, sodass sich der Sensor inhärent wie ein abgestimmter Resonator verhält. Die obere Grenzfrequenz dieses Sensors liegt bei vergleichsweise niedrigen Frequenzwerten. Je grösser der Durchmesser dieses Ringsensors ist, desto länger wird die Laufzeit der Signale auf dem Sensor, und damit sinkt auch die obere Grenzfrequenz des Sensors ab. Bei diesem Sensor wird auch das stets überlagerte Hintergrundgeräusch nicht unschädlich gemacht.

### KURZE DARSTELLUNG DER ERFINDUNG

Der Erfindung, wie sie im Patentanspruch 1 definiert ist, liegt die Aufgabe zugrunde, einen Sensor der eingangs genannten Art zu schaffen, welcher sich einerseits durch einen hohen Wirkungsgrad bei der Auskoppelung der in der Anlage auftretenden Teilentladungsimpulse und eine vergleichsweise hohe obere Grenzfrequenz auszeichnet, und der es andererseits ermöglicht, unerwünschte, den jeweiligen Teilentladungsimpulsen überlagerte, Störungen auszufiltern.

Mit dem erfindungsgemässen Sensor ist es möglich, mit hoher Genauigkeit zu erkennen, dass Teilentladungsimpulse in der metallgekapselten gasisolierten Schaltanlage auftreten, da diese vorteilhaft deutlich von den Geräuschsignalen unterschieden werden.

Der erfindungsgemässe Sensor weist ferner einen vorteilhaft grossen Störabstand zu den in Hochspannungsanlagen häufig auftretenden niederfrequenten Störungen auf.

Die weiteren Ausgestaltungen der Erfindung sind Gegenstände der abhängigen Ansprüche.

Die Erfindung, ihre Weiterbildung und die damit erzielbaren Vorteile werden nachstehend anhand der Zeichnung, welche lediglich einen möglichen Ausführungsweg darstellt, näher erläutert.

### KURZE BESCHREIBUNG DER ZEICHNUNG

Es zeigen:
Fig.1 in stark vereinfachter, schematischer Darstellung einen Schnitt durch eine mit einer ersten Ausführungsform eines Sensors versehene metallgekapselte gasisolierte Hochspannungsanlage,
Fig.2 in stark vereinfachter, schematischer Darstellung einen Teilschnitt durch eine mit einer zweiten Ausführungsform eines Sensors versehene metallgekapselte gasisolierte Hochspannungsanlage, und
Fig.3 in stark vereinfachter, schematischer Darstellung einen Teilschnitt durch eine mit einer dritten Ausführungsform eines Sensors versehene metallgekapselte gasisolierte Hochspannungsanlage.

Bei allen Figuren sind gleich wirkende Elemente mit gleichen Bezugszeichen versehen. Alle für das unmittelbare Verständnis der Erfindung nicht erforderlichen Elemente sind nicht dargestellt.

### WEGE ZUR AUSFÜHRUNG DER ERFINDUNG

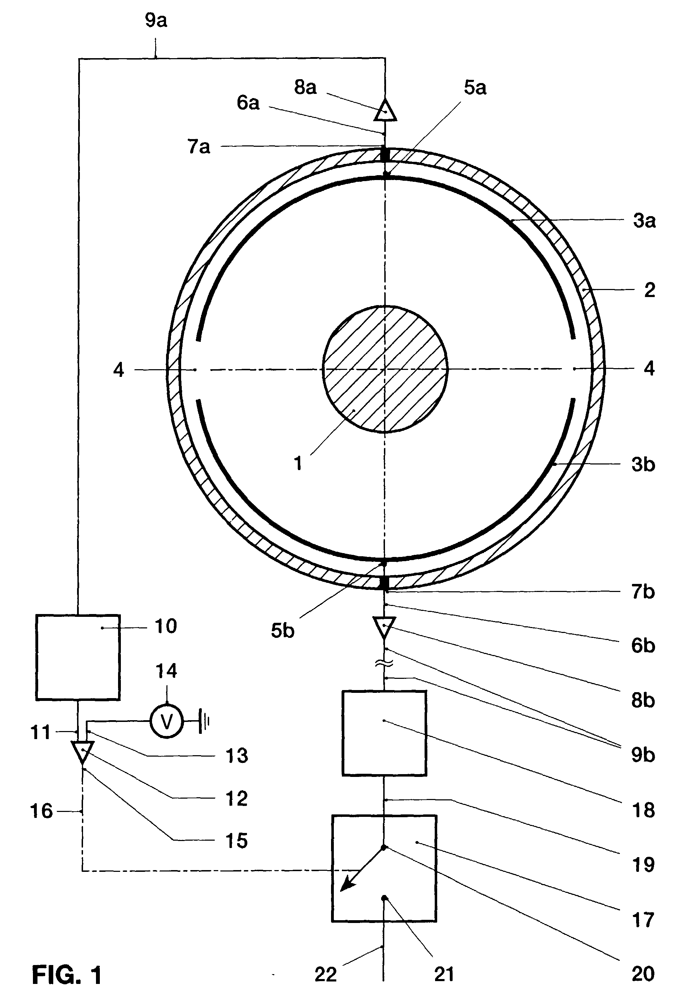

In Fig.1 ist in stark vereinfachter, schematischer Darstellung ein Schnitt durch eine mit einer ersten Ausführungsform eines Sensors versehene metallgekapselte gasisolierte Hochspannungsanlage (GIS) dargestellt. Die Hochspannungsanlage weist im Zentrum einen beispielsweise zylindrisch ausgebildeten, mit Hochspannung beaufschlagten Aktivteil 1 auf. Der sich in axialer Richtung erstreckende Aktivteil 1 wird von nicht dargestellten Isolatoren getragen. Konzentrisch zu diesem Aktivteil 1 ist eine geerdete metallische Kapselung 2 angeordnet. Die Kapselung 2 ist mit einem Isoliergas, wie beispielsweise SF₆, unter Druck gefüllt. Im Inneren der Kapselung 2 sind zwei identisch geformte, halbringförmig ausgebildete, elektrisch leitende Elektroden 3a und 3b in unmittelbarer Nähe der Kapselung 2, eventuell sogar in sie eingelassen, jedoch elektrisch isoliert von dieser, symmetrisch einander gegenüberliegend angeordnet. Zwischen den Elektroden 3a und 3b ist beidseitig je ein Spalt 4 vorgesehen, sodass die beiden Elektroden 3a und 3b elektrisch voneinander isoliert sind. Hier sind beispielsweise zwei gleiche Elektroden 3a und 3b vorgesehen, es ist jedoch ohne weiteres möglich, geradzahlige Vielfache von identisch ausgebildeten Elektroden vorzusehen, von denen dann jeweils die einander diametral gegenüberstehenden Elektroden paarweise zusammenwirkend geschaltet werden. Die geometrische Ausbildung der Elektroden 3a und 3b wird durch die erwartete Frequenz der zu erfassenden Teilentladungsimpulse bestimmt.

In der geometrischen Mitte der Elektroden 3a und 3b ist jeweils eine Anzapfung 5a und 5b vorgesehen, die mit jeweils einer Messleitung 6a und 6b verbunden ist. Die Messleitungen 6a und 6b werden jeweils mittels einer druckdichten Durchführung 7a und 7b aus der Kapselung 2 herausgeführt. Die Messleitungen 6a und 6b sind koaxial ausgebildet. Die Anzapfungen 5a und 5b werden jeweils als Seele in das zugeordnete abgeschirmte Koaxialkabel eingeführt, um eine Beeinflussung der übertragenen Signale durch äussere Störsignale zu verhindern. Vorzugsweise wird hierfür ein abgeschirmtes 50Ω-Koaxialkabel verwendet. Unmittelbar nach dem Austritt aus der Kapselung 2 ist jede der beiden Messleitungen 6a und 6b mit jeweils einem Vorverstärker 8a und 8b versehen, welcher die durch die Elektroden 3a und 3b aufgenommenen Signale verstärkt. Von jedem der beiden Vorverstärker 8a und 8b führt eine koaxial abgeschirmte Leitung 9a und 9b weg, vorzugsweise ist dies ein abgeschirmtes 50Ω-Koaxialkabel. Die beiden Leitungen 9a und 9b sind gleich lang ausgeführt, um etwaige Laufzeitunterschiede der Signale zu vermeiden. Die Anzapfung 5a, die Messleitung 6a, die Durchführung 7a, der Vorverstärker 8a und die Leitung 9a sind elektrisch leitend mit der Elektrode 3a verbunden, die Anzapfung 5b, die Messleitung 6b, die Durchführung 7b, der Vorverstärker 8b und die Leitung 9b sind elektrisch leitend mit der Elektrode 3b verbunden.

Die Leitung 9a führt zu einem Filter 10, der beispielsweise als Tiefpass für etwa 10 MHz ausgelegt ist. Der Ausgang des Filters 10 ist mit einem ersten Eingang 11 eines Komparators 12 verbunden. Ein zweiter Eingang 13 des Komparators 12 ist mit einer einstellbaren Präzisionsspannungsquelle 14 verbunden. Als Komparator 12 kann vorteilhaft ein Schmidt-Trigger eingesetzt werden. Der Komparator 12 weist einen Ausgang 15 auf, der, wie eine Wirkungslinie 16 andeutet, mit einem Analogschalter 17 so zusammenwirkt, dass er Umschaltbefehle in diesen Analogschalter 17 einbringt. Der Analogschalter 17 kann entweder mit Hilfe von digitaler oder analoger Elektronik aufgebaut werden.

Die Leitung 9b ist elektrisch leitend mit einem Filter 18 verbunden. Der Filter 18 ist als Hochpassfilter ausgebildet, welcher die hochfrequenten Teilentladungsimpulse durchlässt. Vom Filter 18 führt eine Leitung 19 zu dem Analogschalter 17 und zwar zu einer Eingangsklemme 20 desselben. Der Analogschalter 17 weist zudem eine Abgangsklemme 21 auf, von der eine Leitung 22 das resultierende Signal abführt in eine nicht dargestellte Erfassungseinrichtung für Teilentladungsimpulse.

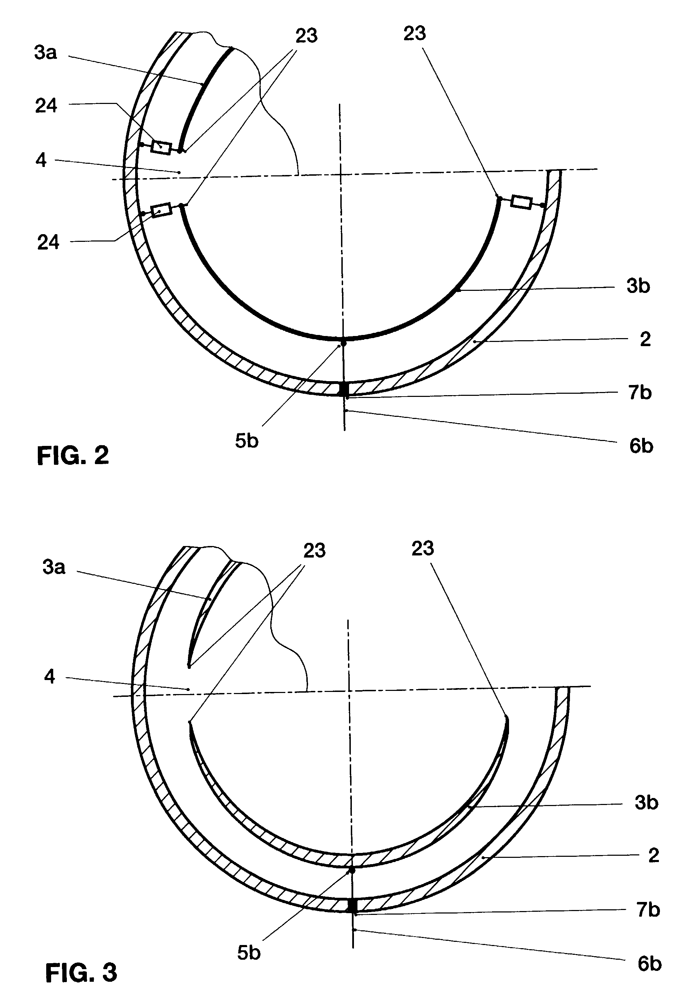

Die Fig.2 zeigt in stark vereinfachter, schematischer Darstellung einen Teilschnitt durch eine mit einer zweiten Ausführungsform eines Sensors versehene metallgekapselte gasisolierte Hochspannungsanlage. Bei dieser Ausführungsform sind die Elektroden 3a und 3b ähnlich ausgebildet wie dies im Zusammenhang mit der Fig.1 beschrieben wurde. Zudem sind jedoch einander zugewandte Enden 23 der Elektroden 3a und 3b über jeweils ein Impedanzanpassungselement 24 mit der Kapselung 2 elektrisch leitend verbunden. Das Impedanzanpassungselement 24 ist hier beispielsweise als ohmscher Widerstand dargestellt. Das Impedanzanpassungselement 24 kann auch als eine elektronische Baugruppe ausgeführt sein, welche zur Anpassung der Impedanz der jeweiligen Elektrode ausgelegt ist. Der sonstige Aufbau des Sensors entspricht der in Fig.1 gezeigten Ausführungsform.

Die Fig.3 zeigt in stark vereinfachter, schematischer Darstellung einen Teilschnitt durch eine mit einer dritten Ausführungsform eines Sensors versehene metallgekapselte gasisolierte Hochspannungsanlage. Bei dieser Ausführungsform sind die Elektroden 3a und 3b geometrisch ähnlich ausgebildet wie in Fig.1 beschrieben, ihr innerer Aufbau unterscheidet sich jedoch grundlegend von den bisher beschriebenen Ausführungsformen. Die Elektroden 3a und 3b bestehen aus einem Material, welches an der Oberfläche eine unterschiedliche Leitfähigkeit für elektromagnetische Wellen aufweist, und zwar ist diese Leitfähigkeit an den Enden 23 geringer als in ihrer geometrischen Mitte, wobei die Leitfähigkeit für die elektromagnetischen Wellen von den Enden 23 her zur geometrischen Mitte hin stetig zunimmt. Die Zunahme dieser Leitfähigkeit für elektromagnetische Wellen kann wegen der besseren Ausführbarkeit auch stufenweise erfolgen. Die Elektroden 3a und 3b können auch einen Träger aus Isoliermaterial aufweisen, der auf der dem Aktivteil 1 zugewandten Seite so beschichtet wird, dass die gewünschten unterschiedlichen Leitfähigkeitswerte erreicht werden. Der übrige Aufbau des Sensors ist gleich wie der bei Fig.1 beschriebene. Derartig aufgebaute Elektroden 3a und 3b wirken ähnlich wie Antennendipole.

Es erweist sich als vorteilhaft, wenn in die Hochspannungsanlage mindestens zwei derartige Sensoren für die Auskopplung von Teilentladungsimpulsen eingebaut werden, da bei der Inbetriebsetzung der eine dieser Sensoren verwendet werden kann für die Einbringung von hochfrequenten Eichimpulsen, mit Hilfe dieser Eichimpulse kann dann der jeweils andere Sensor geeicht werden.

Die Geometrie der Elektroden 3a und 3b kann so angepasst werden, dass gezielt die für die angestrebten Einsatzbereiche des Sensors relevanten Frequenzbereiche besonders gut ausgekoppelt werden können.

Zur Erläuterung der Wirkungsweise wird nun die Fig.1 näher betrachtet. Der dargestellte Sensor ist vorgesehen für das Auskoppeln von Teilentladungsimpulsen aus einer hochspannungsführenden elektrischen Anlage, er arbeitet deshalb in einem Frequenzbereich von etwa 10 MHz bis etwa 1,5 GHz. Die geometrischen Abmessungen der Elektroden 3a und 3b bestimmen die Bandbreite des Frequenzbereichs. Durch die Anpassung der Abmessungen der Elektroden 3a und 3b und gegebenenfalls durch eine entsprechende Auslegung der Impedanzanpassungselemente 24 können bei Bedarf auch andere Frequenzbereiche eingestellt werden. Zudem müssen die Abmessungen der Elektroden 3a und 3b für jede Baugrösse der metallgekapselten gasisolierten Schaltanlage entsprechend angepasst werden. Je nach Baugrösse werden Kapselungen 2 mit unterschiedlichen Durchmessern verwendet, d.h. die Radien der Elektroden 3a und 3b müssen ebenfalls entsprechend angepasst werden. Es wird bei dieser Anpassung jeweils darauf geachtet, dass der Sensor betriebsfrequente, stets ebenfalls in der Hochspannungsanlage auftretende Signale nicht wirksam auskoppelt.

Wenn transiente elektromagnetische Felder, wie sie zum Beispiel durch hochfrequente Teilentladungsimpulse verursacht werden, in der durch den Sensor überwachten Hochspannungsanlage auftreten, so wandern sie durch diese Anlage. Häufig sind in einer Hochspannungsanlage mehrere Sensoren angeordnet, sodass der Ort der Teilentladungsquelle relativ gut eingegrenzt werden kann, sodass zur Fehlerbeseitigung nur ein vergleichsweise kleiner Teil der Anlage demontiert werden muss.

Die beiden Elektroden 3a und 3b des Sensors werden durch das im Innenraum der Kapselung 2 herrschende elektrische Feld beaufschlagt, und zwar in genau gleicher Weise, wenn ein entsprechender gleicher Aufbau dieser Elektroden 3a und 3b vorausgesetzt wird. Das durch jede der beiden Elektroden 3a und 3b im Normalbetrieb der Anlage aufgenommene, kapazitive, vom elektrischen Feld herrührende Geräuschsignal entspricht genau dem jeweiligen, durch die andere Elektrode aufgenommenen kapazitiven Geräuschsignal. Diese beiden Geräuschsignale sind sowohl nach der Grösse als auch nach der Polarität genau gleich. Beim Auftreten von hochfrequenten Teilentladungsimpulsen überlagern sich diese dem stets vorhandenen Geräuschsignal, sodass ein Mischsignal entsteht, dieses Mischsignal wird dann ausgekoppelt. In die Leitungen 9a und 9b gelangt jeweils das gleiche Mischsignal. Das in die Leitung 9a eingespeiste Mischsignal wird mit Hilfe des Filters 10 und des mit einer einstellbaren Präzisionsspannungsquelle 14 zusammenwirkenden Komparators 12 verarbeitet zu einem sogenannten Gating-Signal, welches am Ausgang 15 des Komparators 12 abgegriffen wird. Wie die Wirkungslinie 16 andeutet, wirkt dieses Gating-Signal auf den Analogschalter 17 ein, und zwar so, dass der Analogschalter 17 dann sperrt, wenn das Gating-Signal auf ihn einwirkt.

Das in die Leitung 9b eingespeiste Mischsignal wird mit Hilfe des Filters 18 zu einem eigentlichen Messignal verarbeitet. Dieses Messignal gelangt in den Analogschalter 17, wobei die in diesem Messignal enthaltenen Teilentladungsimpulse nur dann durch den Analogschalter 17 durchtreten können, wenn an diesem kein den Durchtritt sperrendes Gating-Signal ansteht. Es ist demnach sehr wichtig, dass die Leitungen 9a und 9b gleich lang sind, damit keine Laufzeitunterschiede das Arbeiten des Analogschalters 17 verfälschen. Die aus dem Analogschalter 17 austretenden Teilentladungsimpulse werden von der Erfassungseinrichtung für Teilentladungsimpulse registriert und gegebenenfalls wird in dieser Erfassungseinrichtung ein Alarmsignal generiert, um eine Revision der Hochspannungsanlage einzuleiten.

Es ist grundsätzlich auch möglich, die beiden Elektroden 3a und 3b nicht einander gegenüber sondern unmittelbar nebeneinander auf einer Seite der Kapselung 2 anzuordnen, ohne dass dadurch die Wirksamkeit der Messung eingeschränkt wird. Diese Anordnung beansprucht weniger Raum innerhalb der Kapselung 2.

### BEZEICHNUNGSLISTE

- 1: Aktivteil
- 2: Kapselung
- 3a,3b: Elektroden
- 4: Spalt
- 5a,5b: Anzapfung
- 6a,6b: Messleitung
- 7a,7b: Durchführung
- 8a,8b: Vorverstärker
- 9a,9b: Leitung
- 10: Filter
- 11: Eingang
- 12: Komparator
- 13: Eingang
- 14: Präzisionsspannungsquelle
- 15: Ausgang
- 16: Wirkungslinie
- 17: Analogschalter
- 18: Filter
- 19: Leitung
- 20: Eingangsklemme
- 21: Abgangsklemme
- 22: Leitung
- 23: Ende
- 24: Impedanzanpassungselement

## Patentansprüche

1. Sensor zum Auskoppeln von Teilentladungsimpulsen aus einer hochspannungsführenden elektrischen Anlage, insbesondere aus einer mit einer Kapselung (2) aus Metall versehenen gasisolierten Hochspannungsanlage, mit mindestens einer konzentrisch zu den Aktivteilen (1) der Anlage angeordneten, dem elektromagnetischen Feld der Anlage ausgesetzten, etwa ringförmig ausgebildeten Messelektrode, mit mit der Messelektrode verbundenen, die ausgekoppelten Signale verarbeitenden Einrichtungen, dadurch gekennzeichnet,
- dass die etwa ringförmig ausgebildete Messelektrode in mindestens zwei gleiche, voneinander beabstandete, als Elektroden (3a,3b) ausgebildete Segmente aufgeteilt ist,
- dass die mindestens zwei Elektroden (3a,3b) symmetrisch beidseits der Aktivteile (1) angeordnet sind,
- dass die Elektroden (3a,3b) jeweils zwei Enden (23) aufweisen, welche jeweils über ein Impedanzanpassungselement (24) elektrisch leitend mit der Kapselung (2) verbunden sind, und
- dass die die ausgekoppelten Signale verarbeitenden Einrichtungen Mittel aufweisen, für das Ausfiltern von den ausgekoppelten Teilentladungsimpulsen überlagerten Störungen.

2. Sensor nach Anspruch 1, dadurch gekennzeichnet,
- dass die Elektroden (3a,3b) jeweils in ihrer geometrischen Mitte mit einer Anzapfung (5a,5b) versehen sind, und
- dass jede dieser Anzapfungen (5a,5b) als Seele in ein separates abgeschirmtes Koaxialkabel, vorzugsweise ein 50 Ohm-Kabel, eingeführt wird.

3. Sensor nach einem der Ansprüche 1 oder 2, dadurch gekennzeichnet,
- dass als Impedanzanpassungselement (24) jeweils ein ohmscher Widerstand vorgesehen ist.

4. Sensor nach Anspruch 1, dadurch gekennzeichnet,
- dass die Oberflächen der Elektroden (3a,3b) aus für elektromagnetische Wellen unterschiedlich leitfähigem Material aufgebaut sind, wobei jeweils die Enden (23) eine geringere Leitfähigkeit für elektromagnetische Wellen aufweisen als die geometrischen Mitte der Elektroden (3a,3b), wobei diese Leitfähigkeit von den Enden (23) her zur geometrischen Mitte hin stetig oder stufenweise zunimmt.

5. Sensor nach einem der voranstehenden Ansprüche, dadurch gekennzeichnet,
- dass ein von der ersten Elektrode (3a) ausgekoppeltes Signal zu einem Gating-Signal verarbeitet wird,
- dass ein von der zweiten Elektrode (3b) ausgekoppeltes Signal zu einem Messignal verarbeitet wird, und
- dass sowohl das Gating-Signal als auch das Messignal so in einen Analogschalter (17) eingeleitet werden, dass dieser Analogschalter (17) den Durchtritt des Messignals sperrt, solange das Gating-Signal ansteht.

6. Sensor nach Anspruch 5, dadurch gekennzeichnet,
- dass für die Erzeugung des Gating-Signals ein erster, als Tiefpass ausgelegter Filter (10), dem ein mit einer einstellbaren Präzisionsspannungsquelle (14) zusammenwirkender Komparator (12) nachgeschaltet ist, vorgesehen ist, und
- dass für die Erzeugung des Messignals ein zweiter, als Hochpass ausgelegter Filter (18) vorgesehen ist.

7. Sensor nach Anspruch 6, dadurch gekennzeichnet,
- dass als Komparator (12) ein Schmidt-Trigger eingesetzt ist.

8. Sensor nach einem der voranstehenden Ansprüche, dadurch gekennzeichnet,
- dass die beiden Elektroden (3a,3b) unmittelbar nebeneinander auf einer Seite der Kapselung (2) angeordnet sind.
